# EUROPEAN PATENT SPECIFICATION

(11) **EP 1 631 986 B1**
(45) Date of publication and mention of the grant of the patent: **10.08.2011**
(21) Application number: 04739271.7
(22) Date of filing: 19.05.2004
(51) Int. Cl.: H01L 21/78, H01L 21/20, C23C 16/44, C23C 14/00

(54) **A method of preparation of an epitaxial substrate**
Verfahren zur Herstellung eines epitaktischen Substrats
Procédé de fabrication d'un substrat épitaxial

(30) Priority: 06.06.2003 EP 03291371
(43) Date of publication of application: 08.03.2006
(73) Proprietor: S.O.I. Tec Silicon on Insulator Technologies S.A., 38190 Bernin (FR)
(72) Inventor: FAURE, Bruce, F-38000 Grenoble (FR)
(74) Representative: Grünecker, Kinkeldey, Stockmair & Schwanhäusser Anwaltssozietät
(86) International application number: PCT/EP2004/005439
(87) International publication number: WO 2004/112126

(56) References cited:
- EP-A- 0 382 341
- US-A- 5 374 564
- US-A- 5 714 395
- US-A- 6 086 673
- US-B1- 6 440 823
- PATENT ABSTRACTS OF JAPAN vol. 2003, no. 03, 5 May 2003 (2003-05-05) & JP 2002 343718 A (MATSUSHITA ELECTRIC IND CO LTD), 29 November 2002 (2002-11-29)

## Description

The invention relates to a method of preparation of an epitaxial substrate, in particular a GaN, SiGe, AIN or InN epitaxial substrate. and an electronic device manufactured thereon or therein.

Epitaxy is a process during which a crystalline layer of a material is deposited on a substrate, which is also crystalline. The epitaxial growth is characterised in that the crystalline structure of the substrate is reproduced in the epitaxial layer of the material to be grown. Thereby, the defects of the substrate are usually reproduced in the epitaxial layer also. Those epitaxial layers usually find their application in electronic or optoelectronic applications. Of particular interest are, for instance, gallium nitride epitaxial layers which, due to their large band gap, are used in blue, violet or ultraviolet laser diodes.

Epitaxial techniques can be essentially separated into two families. First of all, there is homoepitaxy, wherein the material to be grown is of the same nature as the substrate, which means that essentially their crystallographic structure and their chemical nature are identical. Examples used in industry are the homoepitaxy of silicon on a silicon substrate or the epitaxial growth of gallium arsenide on a substrate of gallium arsenide.

Of even greater interest is so-called heteroepitaxy, wherein the film to be grown is grown on a substrate of a different nature. This is especially important in cases where the desired material is not available in the form of a crystalline substrate. There are two major problems inherent in heteroepitaxy: the difference in the crystalline structure of the two materials, and the difference in their thermal expansion coefficients. These differences lead to stress inside the film and as a consequence to defects such as dislocations.

In addition to the above-mentioned problems leading to insufficient quality of the epitaxial layer, it is also possible that the substrate, due to its intrinsic characteristics, is not fully adapted to the application of the device employing the special characteristic of the epitaxial layer. For example, if one would grow gallium nitride on silicon carbide, relatively good epitaxial growth could be achieved; however, if the gallium nitride structure would be used as a light-emitting device, the silicon carbide substrate would not be advantageous, as it would trap too much light.

In the state of the art, there are several approaches known for overcoming the above-mentioned problems; however, none proposes a substrate which allows homo- as well as heteroepitaxial growth and overcomes each of the three distinct problems mentioned above. For example US 5,759,898 has shown that it is possible to successfully grow an epitaxial silicon germanium thin film on a silicon-on-insulator wafer, wherein the silicon germanium layer grows on a thin silicon film (about 16 nm), which itself is positioned on a layer of silicon dioxide which is in turn positioned on a silicon wafer. In such a structure, the appearance of dislocations in the silicon germanium film is greatly diminished in comparison with a silicon germanium film directly grown on a bulk silicon substrate.

Another approach is shown in WO 99/39377, wherein a so-called compliant substrate is created by ion implantation. In this approach, a fragilised layer inside the material is obtained by ion implantation, which at the same time creates a very thin layer on the top. This top layer is partially isolated from the substrate via the fragilised layer, and absorbs to some extent the mismatch in crystalline structure and thermal expansion of the epitaxial layer to be grown and the top layer of the original substrate, thereby causing at least a partial relaxation of the stress of the epitaxial layer.

These two approaches overcome to some extent the above-mentioned problems; however, due to the presence of the original substrate a negative influence cannot be excluded, and in cases where the presence of the original substrate is incompatible with the application of the grown epitaxial layer, further process steps are needed to remove the original substrate, leading to higher production cost.

US 6,440,823 B1 discloses a process for making defect density (Ga, Al, In)N material serving as a substrate for the epitaxial growth of a Group III-V nitride device structure thereon. US 5,714,395 discloses a process for the manufacture of thin films of semiconductor material comprising the steps of: implantation of ions in a semiconductor wafer to create a cleavage layer of gaseous microblisters in the wafer, heat treatment of the wafer in order to cause separation of the surface layer from the rest of the wafer along the layer of microblisters. According to this document, the implantation is carried out at the depth equal to or greater than a given minimum depth so that the thin film obtained is rigid, and so that the heat treatment can release it.

It is therefore the object of the present invention to provide a process of preparation of an

It is therefore the object of the present invention to provide a process of preparation of an epitaxial substrate which further reduces the influence of the substrate while being at the same time economically viable. The object is solved with a method according to claim 1.

The detachment of the pseudo substrate from the remainder of the base substrate solves, to an important extent, the above-mentioned problems. In cases where a commercially available base substrate is not compatible with the growth of the homo- or

heteroepitaxial layer to be grown, this incompatibility is diminished as the obtained pseudo substrate is independent from the remainder of the substrate, and therefore is hardly affected by the undesirable properties of the later. The influence of the still-present sub-layer can thereby be minimised in the process, and thus does not play a major role.

Concerning the problems of crystallographic structure incompatibility between the base substrate and the desired epitaxial layer, and also the differences in their thermal expansion coefficients, the creation of the pseudo substrate according to the invention is also advantageous, as the stiffening layer provided on top of the base substrate is in itself already being grown by a heteroepitaxial method. This means that by choosing the right material for the stiffening layer, which choice depends on the properties of the base material and the future epitaxial layer, these incompatibilities can already be reduced. Furthermore, strain that might occur during the growth of the desired epitaxial layer on top of the pseudo substrate can be absorbed to a large extent inside the pseudo substrate. Thus, the creation of the pseudo substrates manufactured by the inventive process will already serve to provide better quality epitaxial layers or films.

To achieve an isolated pseudo substrate, the stiffening layer has a thickness sufficient to enable a free-standing character of the pseudo substrate. This means that the pseudo substrate has to be sufficiently robust to withstand the process step of isolation from the remainder of the substrate, or sufficiently stable that it can be taken away from the remainder of the substrate by appropriate means, for example in order to place it in a different apparatus for further processing.

In order to further improve crystalline quality of the epitaxial substrate the temperature ranges during which the growth of the stiffening layer, the detachment and the growth of the homo- or heteroepitaxial layer takes place are such that:
a) the growth of the stiffening occurs in a first temperature range which is chosen such that, at the same time, an epitaxial growth is achieved, but no change of the weak interface occurs which could deform or destroy the pseudo substrate,
b) the growth of the stiffening layer, once it has a sufficient thickness, is stopped and the temperature is raised to further weaken the weak interface to achieve detachment to create the pseudo substrate, in a variant instead of thermal energy mechanical energy may also be applied to achieve detachment at the weak interface, and
c) after the detachment the temperature is chosen such that the growth conditions for the epitaxial layer are optimised to achieved improved crystalline quality.

Thus prior to detachment the temperature is chosen such as to balance crystalline growth and prevention of detachment and after detachment the temperature can be adapted to the growth parameters only.

< Further, the surface of the carrier substrate, which is the surface which does not receive the epitaxial layer to be grown and which is created as a consequence of the detachment, has a surface roughness. Due to this fact, even though the carrier substrate is actually separated from the remainder of the substrate and not influenced by its presence, there will be sufficient friction between the carrier substrate and the remainder of the substrate so that the position of the carrier substrate can be relatively well maintained on top of the remainder of the substrate. Therefore, it is possible to continue with the process in the same deposition apparatus, growing the next layer - which could be another buffer layer or the final epitaxial layer that was intended to be grown - without having to handle the carrier substrate in a specific way, for example securing it on a substrate holder. >

According to an advantageous embodiment the growth of the epitaxial layer can occur in a third temperature range being at a higher temperature than the first temperature range. Thus for the epitaxial layer an optimised growth temperature can be chosen which may be higher than the growth temperature of the stiffening layer, without having to be concerned about stress developing in the remainder of the base substrate.

According to the invention the implantation takes place before providing the stiffening layer. It is known that during ion implantation the implanted ions do not only disturb the crystalline structure on the desired level inside the substrate, but that defects are also introduced into the layer through which the ions travel. This means that if ion implantation were to take place after providing the stiffening layer, the stiffening layer would contain defects that might influence the quality of the epitaxial layer to be grown. Therefore, it is advantageous to perform ion implantation first and then the growth of the stiffening layer.

In a variant of the invention, the sub-layer can have a thickness of up to approximately five micrometers, specifically up to approximately two micrometers, more specifically a thickness of up to approximately one micrometer. Choosing a relatively thick sub-layer has the advantage that in order to achieve the free-standing pseudo substrate the thickness of the stiffening layer can be relatively small, thereby speeding up the process. On the other hand, by choosing a sub-layer of a relatively small thickness, any undesirable properties of the sub-layer material, as for instance light absorbency in optical applications, can be minimised. Thickness control of the sub-layer can easily be managed by adjusting the energy of the ions. The thickness can also be below the values indicated. According to one embodiment, the sub-layer and/or the stiffening layer

can be removed from the pseudo substrate prior to providing the homo- or heteroepitaxial layer on the pseudo substrate.

Advantageously the first temperature range can be from about room temperature to 900°C, more specifically to 800°C, the second temperature range can be from more than 900°C to about 1100°C, and/or the third temperature range starts at temperatures of more than 900°C. For these temperatures epitaxial substrates are achieved with improved crystalline quality, in particular for GaN.

A further preferred embodiment consists of applying, prior to implantation, a sacrificial layer, in particular a thin silicon dioxide (SiO₂ layer), to the surface of the base substrate. Through this sacrificial layer, implantation takes place in a subsequent process step. Doing so helps in protecting the substrate surface from typical organic and particle contamination, which may occur during high-energy ion implantation.

In an advantageous manner, the sacrificial layer can be removed prior to providing the stiffening layer or, in other words, after the ion implantation. As mentioned above, organic contamination can result from high-energy ion implantation. When applying a sacrificial layer, the contamination is fixed on this layer, and by removing the layer in a subsequent step the contamination is also removed. Furthermore, the crystallographic properties or the thermal expansion coefficient of the sacrificial layer might not be suitable for further epitaxial growth of the desired stiffening layer or epitaxial layer.

In a further preferred embodiment, the stiffening layer can be applied by deposition, specifically by epitaxial deposition, more specifically by molecular beam epitaxy (MBE), by metal-organic chemical vapour (MOCVD), by hydride vapour phase epitaxy (HVPE) or by sputtering. These methods will allow the growth of a good quality crystallised stiffening layer, the quality of which is crucial for successful growth of good quality epitaxial layers.

According to another aspect of the invention, the stiffening layer can be grown to a thickness sufficient to enable a self-supporting character of the pseudo substrate, specifically a thickness in a range of at least approximately five micrometers to 50 micrometers, more specifically in a range of at least approximately 10 micrometers to 40 micrometers. These thicknesses are related to the fact that the stiffening layer, eventually together with a sub-layer, provides sufficient stability to the pseudo substrate so that its surface does not become deformed or destroyed during the isolation step.

Prior to providing the stiffening layer, and to improve the quality of the stiffening layer, the surface of the base substrate can be pre-treated, in particular by HF etching, plasma etching or standard cleaning one (SC1) with standard cleaning two (SC2).

A further way to improve the quality of the pseudo substrate can be to provide in addition to the stiffening layer at least one additional layer, which is provided either on top of the stiffening layer or between the base substrate and the stiffening layer. These layers are helpful in overcoming the residual differences in crystallographic structure and thermal expansion. Therefore, by applying these kinds of additional layers, residual stresses can be further diminished, leading to improved epitaxial films.

To even further improve the quality of the epitaxial layer to be grown, in another preferred embodiment at least two additional layers are provided on top of the base substrate, wherein at least one additional layer is provided prior to implanting atomic species. The epitaxy of a first layer or a multi-layer structure on the base substrate is thus performed before the atomic species are implanted. The first layer or the multi-layer structure can then be used as a nucleation layer for the stiffening layer growth, which takes place after the implanting step.

In a further variant of the invention the atomic species are implanted in the at least one additional layer provided prior to implanting the atomic species, therefore creating a layer-like zone inside the at least one additional layer essentially parallel to the surface, and thereby defining a weak interface. This means that after the detachment step, no material from the original substrate is present and thus the residual stress can be further diminished, leading to improved epitaxial films. Actually, in this case the remainder of the base substrate is then constituted out of the entire base substrate itself and the part of the at least one additional layer which is situated below the weak interface towards the base substrate.

In an advantageous manner, the surface of the remainder of the base substrate, after isolation of the pseudo substrate, is polished, in particular by chemical-mechanical polishing (CMP), and re-used as a base substrate in a subsequent pseudo substrate preparation process. This means that eventually out of a relatively expensive mono-crystalline base substrate, a certain, non-negligible amount of high quality pseudo substrates can be manufactured.

In a further preferred embodiment, the base substrate is made out of one of the group of silicon, silicon carbide, sapphire, gallium arsenide, indium phosphide (InP) or germanium (Ge). For epitaxial growth, these substrates are usually mono-crystalline and can present surfaces of various crystalline directions. These substrates are readily available and because their properties vary, they form a good base for growing a large number of different pseudo substrates, thereby permitting the growth of an even larger amount of epitaxial layers with good crystalline properties.

To even further improve the quality of the epitaxial layer to be grown, in another preferred embodiment the epitaxial stiffening layer is made of the same material as the homo- or heteroepitaxial layer to be grown, such that the homo- or heteroepitaxial layer grows in an homoepitaxial growth mode. This means that between the epitaxial film and the pseudo substrate there is nearly no difference in crystalline structure and thermal expansion coefficients, resulting in high quality epitaxial films.

In a further variant of the invention, the stiffening layer can have a crystalline structure and/or a thermal expansion coefficient similar to that of the homo- or heteroepitaxial layer, such that the homo- or heteroepitaxial layer grows in a heteroepitaxial growth mode. When the difference in crystalline structure or thermal expansion coefficient of the base substrate and the intended epitaxial film would be too great, it is advantageous to choose a stiffening layer of a material that has its properties somewhere in between those two values. By doing so, a good crystalline quality of the stiffening layer can be obtained and also in subsequent fabrication steps a good quality epitaxial film.

In a preferred embodiment the stiffening layer can be made out of one or several of the group of gallium nitride (GaN), aluminum nitride (AIN), indium nitride (InN), silicon germanium (SiGe), indium phosphite (InP), gallium arsenide (GaAs) or alloys made out of those materials, like AlGaN, InGaN, InGaAs, or AlGaAs. These materials are particularly of interest for electronic as well as opto-electronic applications and can be arranged in the form of several layers within the stiffening layer.

In cases where an additional or several layers are provided between the base substrate and the stiffening layer of gallium nitride or the like, it is especially advantageous that the buffer layer is made out of one or several of the group of AIN, GaN, AlGaN or a combination thereof depending on the materials of the base substrate and the stiffening layer. By using these materials as buffer layers, eventually occurring constraints can be limited, leading to an amelioration of the quality of the epitaxial films to be grown on the pseudo substrate. These materials can be arranged in the form of several layers.

In a further variant of the invention, the back side surface of the pseudo substrate, which is the surface which does not receive the homo- or heteroepilaxial layer and which is created as a consequence of the detachment, has a surface roughness in a range of approximately 20-200 A RMS, specifically in a range of approximately 20-150 A RMS. more specifically in a range of approximately 20-100 A RMS.

The invention relates also to an electronic device, manufactured on or in the epitaxial substrate manufactured according to the above described process.

Specific embodiments of the present invention will become more apparent from the following detailed description with reference to the accompanying drawing, in which:

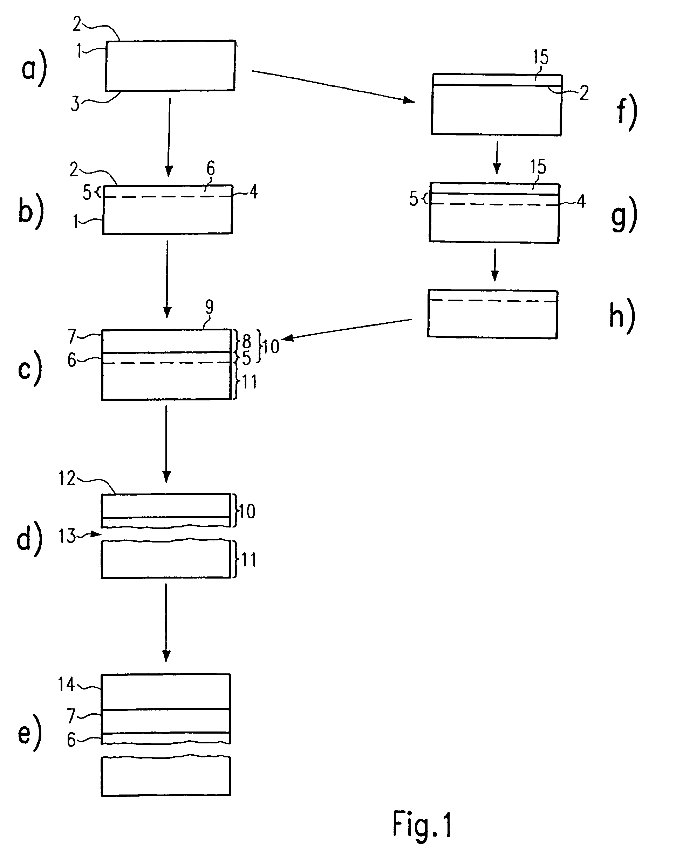

Fig. 1 schematically shows an inventive preparation process diagram for the preparation of an epitaxial substrate; wherein
Figs. 1a to 1e schematically show the preparation method of the epitaxial substrate according to a first embodiment,;
Figs. 1f to 1h schematically show a second embodiment which consists of additional processing steps,

The process, shown in Figs. 1 a -1h, can be run, for instance, on a Smart-cut^{®}-like process production line

Fig. 1 a shows a base substrate which acts as the starting point of the preparation process of the epitaxial substrate. This substrate 1 has a front side 2 and a back side 3. For homo- or heteroepitaxial applications, the base substrate is usually of a crystalline, in particular a mono-crystalline type. At least one surface, here the front side 2, is sufficiently well-defined to serve as a starting point for the growth of an epitaxial, homo- or heteroepitaxial layer or film. Usually, the surface is polished and prepared for epitaxy, and substantially in accordance with typical crystalline directions. The exact size of the base substrate 1 is not of major importance, but at least the surface of the front side 2 should be sufficiently large to allow the growth of a sufficiently big epitaxial substrate suitable to the subsequent needs of the devices. Particularly relevant are wafers made out of silicon, silicon carbide, sapphire, gallium arsenide, indium phosphide or germanium. These wafers are usually disc-shaped, but rectangular or square formats are also available. Disc-like wafers can have diameters of from 50.8 mm (2 inches) up to 300 mm today, but even larger diameters are foreseen for the future.

Fig. 1b shows the result of the next process step. Gaseous species, in particular hydrogen ions, are implanted into the base substrate 1. The implantation takes place through the front side 2 of the base substrate 1. The implanted species create a weak layer-like zone 4, which is essentially parallel to the front-side surface 2 of the base substrate 1. The depth 5 of the layer-like zone 4 can be adjusted by the energy of the implanted species. For example, in the case of hydrogen atoms implanted into silicon carbide, an energy of approximately 100 KeV creates the layer-like zone at a depth of approximately 6000 A. The zone between the surface 2 and the layer-like zone 4 defines the sub-layer 6. It is particularly advantageous to apply a Smart-cut^{®} process to the ion implantation.

Fig. 1c shows the result of the subsequent processing step, which is the deposition of the stiffening layer 7. At the beginning of the process, the base substrate 1 has been chosen so that its material is compatible with the epitaxy of the stiffening layer 7. In particular, it should be compatible with heteroepitaxial growth.

In this first epitaxial growth step, the stiffening layer is grown to a thickness of approximately 1 to 50 micrometers. The thickness 8 of the stiffening layer 7 plus the thickness 5 of the sub-layer 6 needs to be sufficient to create a pseudo substrate 10 that is free-standing, which means that the quality of the surface 9 of the stiffening layer 7 does not deteriorate at or after the point when the pseudo substrate 10 becomes separated from the remainder of the base substrate 11. Typical stiffening layer materials are gallium nitride (GaN), aluminum nitride (AIN), indium nitride (InN), silicon germanium (SiGe), indium phosphite (InP), gallium arsenide (GaAs) or alloys made out of those materials, like AlGaN, InGaN, InGaAs, AlGaAs. However, in future applications it is possible that other materials need to play the role of stiffening layer. Usually, the stiffening layer 7 can be applied by any deposition method leading to epitaxial growth. However, growth by molecular beam epitaxy (MBE), metal-organic chemical vapour (MOCVD), hydride vapour phase epitaxy (HVPE) or sputtering is particularly suitable.

The temperature at which the growth of the stiffening layer 7 takes place is chosen such that epitaxial growth occurs, without however that already a detachment at the weak interface 4 occurs, which could be disadvantageous for the quality of the stiffening layer or may even lead to a destruction of the stiffening layer. Typically the stiffening layer is grown at temperatures being lower than 900°C.

Fig. 1d shows the result of the subsequent process step, which is the thermal treatment of the created structure, ones the growth of the stiffening layer has been terminated, leading to the detachment of the pseudo substrate 10 from the remainder of the base substrate 11. Due to the fact that the total thickness sum of thickness 5 and 8 of the pseudo substrate 10 is sufficient to prevent the formation of defects of the morphology of the surface 12 opposite to the zone 13 where the fracture occurs, the surface 12 does not deteriorate. The roughness of the surface 13 where the fracture occurs is sufficient to keep the pseudo substrate 10 in a secure position on top of the remainder of the substrate 11 due to frictional interaction. This can be advantageous for the subsequent process steps, in particular when the subsequent process steps are performed in the same apparatus without removing the pseudo substrate 10. Typically, roughnesses in the range of approximately 20-200 A RMS, more specifically in a range of approximately 20-150 A RMS and even more specifically in a range of approximately 20-100 A RMS can be achieved in such a process.

The detachment occurs at temperatures higher than the one during the growth process of the stiffening layer 7. A typical temperature would be 900°C.

Fig. 1e shows the result of a subsequent processing step, which is the epitaxial growth of the desired material leading to a homo- or heteroepitaxial layer thus creating the epitaxial substrate, constituted out of the layers 6, 7 and 14. During this second deposition step, performed in a manner similar to the first one, but wherein now the temperature can be chosen optimum with respect to the epitaxial growth without that it is necessary to take into account a detachment process, the homo- or heteroepitaxial layer 14 is obtained.

Depending on the goal of the process, the material of the second layer 14 can be the same as the material of the stiffening layer 7 of the pseudo substrate 11 or, in a heteroepitaxial growth, the material of layer 14 can be different from that of the stiffening layer 7. As the pseudo substrate 10 is detached from the remainder of the base substrate 11, the crystalline quality of this second layer 14 is very good. Defects due to the stress can be minimised. Usually negative effects of the sub-layer 6 of the pseudo substrate 10, which contains the material of the base substrate 1, can be ignored, as its thickness is usually chosen to be clearly inferior to that of the stiffening layer 7, which in fact means that this pseudo substrate 11 behaves like a bulk substrate of the material of the stiffening layer 7.

This also means that the thickness of the second film 14, especially in cases where the material of layer 14 and of layer 7 is the same, is not limited. It is even possible to grow a film 14 with a laterally variable thickness. Actually the pseudo substrate 10 does not impose limitations on the structure or thickness of the second layer 14. The process can be applied, for example, to grow mono-crystals of excellent quality, especially where the two materials of layer 14 and 7 are the same; or heterostructures can be built, leading to devices like laser diodes.

In an optional processing step (not shown), the sub-layer 6 can be removed, for example by using a dry or humid etch technique.

The remainder 11 of the base substrate 1 can be polished, in particular by chemical-mechanical polishing (CMP), and be re-used as a base substrate 1 in a subsequent pseudo substrate 10 or epitaxial substrate manufacturing process.

Figs. 1f to 1h show a variant of the already described process. With respect to the first embodiment, they fit in between the process steps shown in Figs. 1 a and 1 c and thereby replace the process step corresponding to Fig. 1 b.

Fig. 1f shows the result of the process step consisting of depositing a sacrificial layer 15 on top of the base substrate 1. This sacrificial layer 15 is for example made out of silicon dioxide, deposited by one of the usual methods known in the prior art. This sacrificial layer protects the front side 2 of the base substrate 1 from organic and particle contamination which might occur during the subsequent ion implantation process step.

Fig. 1g shows the result of the ion implantation step. It is comparable to the process step described in combination with Fig. 1 b. However, due to the presence of the sacrificial layer 15 the depth 5 of the layer-like zone 4 is smaller than in the first embodiment, because at the same energy level the gaseous species now have to travel through the sacrificial layer and, as a consequence, stop at a depth 5 which is lower.

Fig. 1h shows the result of the sacrificial layer removal step. After the ion implantation, the sacrificial layer 15 is removed in order to achieve a clean front side 2 surface of the base substrate 1. The next step is the growth of the stiffening layer which is comparable to what has been described with respect to Fig. 1 c.

Several further alternatives lead to different embodiments. They are not shown in the Figures, but will be briefly explained below.

In order to further improve the quality of the stiffening layer 7 as well as the second homo or heteroepitaxial layer 14, further steps can be included. Prior to applying the stiffening layer, the front side surface 2 can be prepared in order to facilitate the nucleation of the epitaxial stiffening layer 7. Chemical etching using hydrofluoric acid (HF), plasma etching, standard cleaning one (SC1) with standard cleaning two (SC2) or any other suitable cleaning technique may be used to achieve this. It is also possible to use a thermal oxidation and oxide removal before the ion implantation, in order to remove surface defects from the base substrate 1.

It is also possible to use at least one additional layer as a buffer layer in order to improve the quality of the stiffening layer 7. These additional layers grown on the base substrate 1 relieve any stress that might occur inside the stiffening layer 7. Typical materials are aluminum nitride, gallium nitride, aluminum gallium nitride or a combination thereof. Sophisticated buffer techniques like lateral overgrowth or the like can also be applied. The same kind of additional layers can also be applied between the pseudo substrate 10 and the desired homo- or heteroepitaxial layer 14. It is possible to grow the additional layers before and/or after the implantation step. In a further variant, implantation places the weak zone inside one of the additional layers that have been grown prior to implantation.

Eventually after the growth of the homo- or heteroepitaxial layer 14 further layers can be grown on the substrate.

Ideally, at least process steps 1 c to 1 e take place in one apparatus without moving the pseudo substrate 10, thus reducing the risks of introducing contamination or scratches on or in the pseudo substrate. Alternatively, if it is advantageous for the planned process, it is possible to separate the pseudo substrate 10 from the remainder of the substrate 11 after step 1d. Therefore, the thickness of the pseudo substrate needs to be sufficient for it to be handled and moved from one apparatus to another.

The homo or heteroepitaxial films 14 that can be obtained by this preparation method are in particular films made out of gallium nitride, silicon germanium, aluminum nitride or indium nitride. Below, an example of fabrication of an epitaxial gallium nitride film on a silicon carbide base substrate will be described in detail.

As a base substrate, mono-crystalline silicon carbide of a 6H or 4H poly type with silicon terminated surface, or 3C (three cubic) silicon carbide is provided. Alternatively, the process could also be applied to a base substrate made out of sapphire. Ion implantation is performed using hydrogen ions with a dose between 2 and 8 x 10¹⁶ H+/cm² with an energy between 30 and 210 KeV, in particular a dose of 5 x 10¹⁶ H+/cm² with an energy of 120 KeV. The ions are implanted through the front side surface 2 of the base substrate 1. As mentioned above, a sacrificial layer 15 can be used to prevent contamination. In the case of silicon carbide it is possible to grow a silicon dioxide layer of a couple of hundred A by thermal process. After implantation, the silicon dioxide can be removed using hydrofluoric acid (HF), in a ten percent concentration. Usually a 20 minute period of time is sufficient to remove the oxide layer.

In the next step, gallium nitride is deposited on the implanted silicon carbide base substrate by means of MBE at a temperature of less than 800°C. This first epitaxial layer corresponds to the stiffening layer 7 and has a thickness of some microns. Alternatively, prior to depositing gallium nitride, a buffer technique can be used. Another alternative is to clean the surface prior to deposition by chemical etching using hydrofluoric acid, or by plasma etching or SC1 with SC2 cleaning.

In the next step, the sample is heated to a temperature of more than or equal to 900°C and a fracture between the pseudo substrate 10 and the remainder of the silicon carbide base substrate 11 takes place. Then the second epitaxial growth step occurs, wherein gallium nitride is grown to a thickness of up to about 200-300 micrometers, whereby the growth speed can be relatively high, e.g. 50 µm per hour. This growth step takes place at a temperature of more than 900°C, for which the growth conditions to obtain an epitaxial film with improved crystalline quality is further improved.

Finally, the substrate and the newly grown gallium nitride layer are brought back to room temperature and it is possible to separate the gallium nitride film from the substrate. Using chemical means, the back side of the gallium nitride can be cleaned, so that any remaining silicon carbide is removed. The original silicon carbide base substrate will be recycled by polishing its surface using chemical-mechanical polishing.

## Claims

1. A method of preparation of an epitaxial substrate, in particular a GaN, SiGe, AIN or InN epitaxial substrate, comprising the steps of:
providing a crystalline base substrate (1),
implanting atomic species, in particular hydrogen ions and/or rare gas, in the base substrate (1), creating a layer-like zone (4) inside the base substrate (1) essentially parallel to a surface (2) of the base substrate (1), thereby defining a weak interface between a remainder of the base substrate (11) and a sub-layer (6),
then growing a heteroepitaxial stiffening layer (7) over the surface of the sub-layer (6) of the base substrate (1) in a first predetermined temperature range lower than 900°C,
detaching the stiffening layer (7) together with a sub-layer (6) of the base substrate (1) from the remainder of the base substrate (11) due to a thermal treatment in a second predetermined temperature range, being higher than the first temperature range, to create a pseudo-substrate (10),
growing a homo- or heteroepitaxial layer (14) over the stiffening layer (7) of the pseudo substrate (10), and
keeping the pseudo substrate (10) in a secure position on top of the remainder of the substrate (11) due to roughness induced frictional interaction between the pseudo substrate and the remainder of the base substrate for growing the homo- or heteroepitaxial layer (14).

2. A method of preparation of an epitaxial substrate according to claim 1, wherein the growth of the homo- or heteroepitaxial layer (14) occurs in a third predetermined temperature range, being higher than the first predetermined temperature range.

3. A method of preparation of an epitaxial substrate according to one of claims 1 to 2, **characterized in that** the sub-layer (6) has a thickness of up to approximately 5µm, specifically up to approximately 2µm, more specifically a thickness of up to approximately 1µm.

4. A method of preparation of an epitaxial substrate according to at least one of claims 1 to 3 **characterised in that** the first temperature range is from about room temperature to 900°C, more specifically to 800°C, the second temperature range is from more than 900°C to about 1100°C, and/or the third temperature range starts at a temperature of more than 900°C.

5. A method of preparation of an epitaxial substrate according to at least one of claims 1 to 4 **characterised in that** prior to implantation a sacrificial layer (15), in particular a thin silicon dioxide (SiO₂) layer, is applied to the surface (2) of the base substrate (1), through which implantation will take place.

6. A method of preparation of an epitaxial substrate according to claim 5 **characterised in that** the sacrificial layer (15) is removed prior to providing the stiffening layer (7).

7. A method of preparation of an epitaxial substrate according to at least one of claims 1 to 6 **characterised in that** the stiffening layer (7) is applied by deposition, in particular by epitaxial deposition, more particularly by molecular beam epitaxy (MBE), by metal-organic chemical vapour (MOCVD), by hydride vapour phase epitaxy (HVPE) or by sputtering.

8. A method of preparation of an epitaxial substrate according to at least one of the claims 1 to 7 **characterised in that** the stiffening layer (7) is grown to a thickness sufficient to enable a self-supporting character of the pseudo substrate (10), specifically to a thickness in a range of approximately 5µm to 50µm, more specifically in a range of approximately 10µm to 40µm.

9. A method of preparation of an epitaxial substrate according to at least one of the claims 1 to 8 **characterised in that** prior to providing the stiffening layer (7), the surface (2) of the base substrate (1) is pre-treated, in particular by HF etching, plasma etching or standard cleaning one (SC1) with standard cleaning two (SC2).

10. A method of preparation of an epitaxial substrate according to at least one of the claims 1 to 9 **characterised in that** in addition to the stiffening layer (7) there is provided at least one additional layer either on top of the stiffening layer or between the base substrate (1) and the stiffening layer (7).

11. A method of preparation of an epitaxial substrate according to claim 10 **characterised in that** at least two additional layers are provided on top of the base substrate, thereby creating a modified base substrate and wherein at least one additional layer is provided prior to implanting atomic species.

12. A method of preparation of an epitaxial substrate according to claim 11 **characterised in that** the atomic species are implanted in the at least one additional layer of the modified base substrate, provided prior to implanting the atomic species, creating a layer-like zone inside the at least one additional layer essentially parallel to the surface, thereby defining a weak interface.

13. A method of preparation of an epitaxial substrate according to at least one of the claims 10 to 12 **characterised in that** the additional layer between the base substrate (1) and a stiffening layer (7) of GaN or the like is a buffer layer, the buffer layer being made out of one or several of the group of AIN, GaN, AlGaN or a combination thereof.

14. A method of preparation of an epitaxial substrate according to at least one of the claims 10 to 13 **characterised in** keeping the pseudo substrate (10) in a secure position on top of the remainder of the substrate (11) due to friction between the pseudo substrate (10) and the remainder of the substrate (11) for growing the additional layer on the pseudo substrate (10).

15. A method of preparation of an epitaxial substrate according to at least one of the claims 1 to 14 **characterised in that** the remainder of the base substrate (11) is polished, in particular by chemical mechanical polishing, and reused as a base substrate (1) in a subsequent pseudo-substrate (10) preparation process after the growing of the homo- or heteroepitaxial layer (14).

16. A method of preparation of an epitaxial substrate according to at least one of the claims 1 to 15 **characterised in that** the base substrate (1) is made out of one of the group of silicon, silicon carbide, sapphire, gallium arsenide, indium phosphide (InP) or germanium (Ge).

17. A method of preparation of an epitaxial substrate according to at least one of the claims 1 to 16 **characterised in that** the epitaxial stiffening layer (7) is made of the same material as the homo- or heteroepitaxial layer (14), such that the homo- or heteroepitaxial layer (14) grows in a homoepitaxial growth mode.

18. A method of preparation of an epitaxial substrate according to at least one of the claims 1 to 17 **characterised in that** the stiffening layer (7) has a crystalline structure and a thermal expansion coefficient similar to that of the homo- or heteroepitaxial layer (14), such that the homo- or heteroepitaxial layer (14) grows in a heteroepitaxial growth mode.

19. A method of preparation of an epitaxial substrate according to at least one of the claims 1 to 18 **characterised in that** the stiffening layer (7) is made out of one or several of the group of gallium nitride (GaN), aluminum nitride (AIN), indium nitride (InN), silicon germanium (SiGe), indium phosphide (InP), gallium arsenide (GaAs) or alloys made out of those materials, like AIGaN, InGaN; InGaAs or AlGaAs.

20. A method of preparation of an epitaxial substrate according to at least one of the claims 1 to 19 **characterised in that** the the homo- or heteroepitaxial layer (14) is grown in the same apparatus as the stiffening layer (7).

21. A method of preparation of an epitaxial substrate according to claims 14 and 20 **characterised in that** the the additional layer on the pseude substrate (10) is grown in the same apparatus as the stiffening layer (7).

## Patentansprüche

1. Verfahren zum Fertigen eines Epitaxie-Substrats, insbesondere eines GaN-, SiGe-, AlN- oder InN-Epitaxie-Substrats, das die folgenden Schritte umfasst:
Bereitstellen eines kristallinen Basis-Substrats (1),
Implantieren atomarer Spezies, insbesondere Wasserstoff-Ionen und/oder Edelgas in das Basis-Substrat (1) und Schaffen einer schichtartigen Zone (4) im Inneren des Basis-Substrat (1) im Wesentlichen parallel zu einer Oberfläche (2) des Basis-Substrats (1), um so eine schwache Grenzfläche zwischen einem Rest des Basis-Substrats (1) und einer Unterschicht (6) auszubilden,
anschließend Aufwachsen einer heteroepitaktischen Versteifungsschicht (7) über der Oberfläche der Unterschicht (6) des Basis-Substrats (1) in einem ersten vorgegebenen Temperaturbereich unter 900 °C,
Lösen der Versteifungsschicht (7) zusammen mit einer Unterschicht (6) des Basis-Substrats (1) vom Rest des Basis-Substrats (11) aufgrund einer Wärmebehandlung in einem zweiten vorgegebenen Temperaturbereich, der höher ist als der erste Temperaturbereich, um ein Pseudo-Substrat (10) zu schaffen,
Aufwachsen einer homo- oder heteroepitaktischen Schicht (14) über der Versteifungsschicht (7) des Pseudo-Substrats (10), und
Halten des Pseudo-Substrats (10) in einer sicheren Position auf dem Rest des Substrats (11) aufgrund durch Rauhigkeit bewirkter Reibungswechselwirkung zwischen dem Pseudo-Substrat und dem Rest des Basis-Substrats zum Aufwachsen der homo- oder heteroepitaktischen Schicht (14).

2. Verfahren zum Fertigen eines Epitaxie-Substrats nach Anspruch 1, wobei das Aufwachsen der homo- oder heteroepitaktischen Schicht (14) in einem dritten vorgegebenen Temperaturbereich stattfindet, der höher ist als der erste vorgegebene Temperaturbereich.

3. Verfahren zum Fertigen eines Epitaxie-Substrats nach einem der Ansprüche 1 bis 2, **dadurch gekennzeichnet, dass** die Unterschicht (6) eine Dicke von bis zu ungefähr 5 µm, insbesondere bis zu ungefähr 2 µm, und im Einzelnen eine Dicke bis zu ungefähr 1 µm hat.

4. Verfahren zum Fertigen eines Epitaxie-Substrats nach wenigstens einem der Ansprüche 1 bis 3, **dadurch gekennzeichnet, dass** der erste Temperaturbereich ungefähr von Raumtemperatur bis 900 °C, insbesondere bis 800 °C, reicht, der zweite Temperaturbereich von über 900°C bis ungefähr 1100 °C reicht und/oder der dritte Temperaturbereich bei einer Temperatur von mehr als 900 °C beginnt.

5. Verfahren zum Fertigen eines Epitaxie-Substrats nach wenigstens einem der Ansprüche 1 bis 4, **dadurch gekennzeichnet, dass** vor der Implantation eine Opferschicht (15), insbesondere eine dünne Schicht aus Siliziumdioxid (SiO₂), auf die Oberfläche (2) des Basis-Substrats (1) aufgebracht wird, durch die hindurch Implantation stattfindet.

6. Verfahren zum Fertigen eines Epitaxie-Substrats nach Anspruch 5, **dadurch gekennzeichnet, dass** die Opferschicht (15) vor dem Schaffen der Versteifungsschicht (7) entfernt wird.

7. Verfahren zum Fertigen eines Epitaxie-Substrats nach wenigstens einem der Ansprüche 1 bis 6, **dadurch gekennzeichnet, dass** die Versteifungsschicht (7) durch Abscheidung, insbesondere durch epitaktische Abscheidung, und im Einzelnen durch Molekularstrahlepitaxie (MBE), durch metallorganische chemische Bedampfung (MOCVD), durch Hydridgasphasenepitaxie (HVPE) oder durch Sputtern aufgetragen wird.

8. Verfahren zum Fertigen eines Epitaxie-Substrats nach wenigstens einem der Ansprüche 1 bis 7, **dadurch gekennzeichnet, dass** die Versteifungsschicht (7) auf ein Dicke aufgewachsen wird, die ausreicht, um einen selbsttragenden Charakter des Pseudo-Substrats zu ermöglichen, insbesondere auf eine Dicke in einem Bereich von ungefähr 5 µm bis 50 µm und im Einzelnen in einem Bereich von ungefähr 10 µm bis 40 µm.

9. Verfahren zum Fertigen eines Epitaxie-Substrats nach wenigstens einem der Ansprüche 1 bis 8, **dadurch gekennzeichnet, dass** vor dem Bereitstellen der Versteifungsschicht (7) die Oberfläche (2) des Basis-Substrats (1) vorbehandelt wird, insbesondere mittels HF-Ätzen, Plasmaätzen oder Standard Clean 1 (SC1) mit Standard Clean 2 (SC2).

10. Verfahren zum Fertigen eines Epitaxie-Substrats nach wenigstens einem der Ansprüche 1 bis 9, **dadurch gekennzeichnet, dass** zusätzlich zu der Versteifungsschicht (7) wenigstens eine zusätzliche Schicht entweder auf der Versteifungsschicht oder zwischen dem Basis-Substrat (1) und der Versteifungsschicht (7) geschaffen wird.

11. Verfahren zum Fertigen eines Epitaxie-Substrats nach Anspruch 10, **dadurch gekennzeichnet, dass** wenigstens zwei zusätzliche Schichten auf dem Basis-Substrat geschaffen werden, um so ein modifiziertes Basis-Substrat zu erzeugen, und wobei wenigstens eine zusätzliche Schicht vor dem Implantieren atomarer Spezies geschaffen wird.

12. Verfahren zum Fertigen eines Epitaxie-Substrats nach Anspruch 11, **dadurch gekennzeichnet, dass** die atomaren Spezies in der wenigstens einen zusätzlichen Schicht des modifizierten Basis-Substrats implantiert werden, das vor dem Implantieren der atomaren Spezies geschaffen wird, und eine schichtartige Zone im Inneren der wenigstens einen zusätzlichen Schicht im Wesentlichen parallel zu der Oberfläche erzeugt wird, um so eine schwache Grenzfläche auszubilden.

13. Verfahren zum Fertigen eines Epitaxie-Substrats nach wenigstens einem der Ansprüche 10 bis 12, **dadurch gekennzeichnet, dass** die zusätzliche Schicht zwischen dem Basis-Substrat (1) und einer Versteifungsschicht (7) aus GaN oder dergleichen eine Pufferschicht ist, wobei die Pufferschicht aus einer oder mehreren Verbindungen der Gruppe aus AIN, GaN, AlGaN oder einer Kombination daraus besteht.

14. Verfahren zum Fertigen eines Epitaxie-Substrats nach wenigstens einem der Ansprüche 10 bis 13, **dadurch gekennzeichnet, dass** das Pseudo-Substrat (10) aufgrund von Reibung zwischen dem Pseudo-Substrat (10) und dem Rest des Substrats (11) zum Aufwachsen der zusätzlichen Schicht auf dem Pseudo-Substrat (10) in einer sicheren Position auf dem Rest des Substrats (11) gehalten wird.

15. Verfahren zum Fertigen eines Epitaxie-Substrats nach wenigstens einem der Ansprüche 1 bis 14, **dadurch gekennzeichnet, dass** der Rest des Basis-Substrats (11) poliert wird, insbesondere mittels chemisch-mechanischem Polieren, und in einem folgenden Prozess zum Fertigen eines Pseudo-Substrats (10) nach dem Aufwachsen der homo- oder heteroepitaktischen Schicht (14) als ein Basis-Substrat (1) wiederverwendet wird.

16. Verfahren zum Fertigen eines Epitaxie-Substrats nach wenigstens einem der Ansprüche 1 bis 15, **dadurch gekennzeichnet, dass** das Basis-Substrat (1) aus wenigstens einem der Elemente der Gruppe aus Silizium, Siliziumkarbid, Saphir, Galliumarsenid, Indiumphosphid (InP) oder Germanium (Ge) besteht.

17. Verfahren zum Fertigen eines Epitaxie-Substrats nach wenigstens einem der Ansprüche 1 bis 16, **dadurch gekennzeichnet, dass** die epitaktische Versteifungsschicht (7) aus dem gleichen Material besteht wie die homo- oder heteroepitaktische Schicht (14), so dass die homo- oder heteroepitaktische Schicht (14) in einem homoepitaktischen Aufwachs-Modus wächst.

18. Verfahren zum Fertigen eines Epitaxie-Substrats nach wenigstens einem der Ansprüche 1 bis 17, **dadurch gekennzeichnet, dass** die Versteifungsschicht (7) eine kristalline Struktur und einen Wärmeausdehnungskoeffizienten hat, der dem der homo- oder heteroepitaktischen Schicht (14) gleicht, so dass die homo- oder heteroepitaktische Schicht (14) in einem heteroepitaktischen Aufwachs-Modus wächst.

19. Verfahren zum Fertigen eines Epitaxie-Substrats nach wenigstens einem der Ansprüche 1 bis 18, **dadurch gekennzeichnet, dass** die Versteifungsschicht (7) aus einem oder mehreren der Elemente der Gruppe aus Galliumnitrid (GaN), Aluminiumnitrid (AIN), Indiumnitrid (InN), Silizium-Germanium (SiGe), Indiumphosphid (InP), Galliumarsenid (GaAs) oder aus diesen Materialien bestehenden Legierungen, wie beispielsweise AlGaN, InGaN; InGaAs oder AlGaAs, besteht.

20. Verfahren zum Fertigen eines Epitaxie-Substrats nach wenigstens einem der Ansprüche 1 bis 19, **dadurch gekennzeichnet, dass** die homo- oder heteroepitaktische Schicht (14) in der gleichen Vorrichtung aufgewachsen wird wie die Versteifungsschicht (7).

21. Verfahren zum Fertigen eines Epitaxie-Substrats nach den Ansprüchen 14 und 20, **dadurch gekennzeichnet, dass** die zusätzliche Schicht auf dem Pseudo-Substrat (10) in der gleichen Vorrichtung aufgewachsen wird wie die Versteifungsschicht (7).

## Revendications

1. Procédé de fabrication d'un substrat épitaxial, en particulier un substrat épitaxial en GaN, SiGe, AIN ou InN, comprenant les étapes consistant à :
fournir un substrat de base cristallin (1),
implanter une espèce atomique, en particulier des ions hydrogène et/ou un gaz rare, dans le substrat de base (1), créer une zone(4) à l'intérieur du substrat de base (1) parallèle pour l'essentiel à une surface (2) du substrat de base (1), ce qui définit ainsi une interface de faiblesse entre le reste du substrat de base (11) et une sous-couche (6),
puis faire croître une couche hétéro-épitaxiale de renforcement (7) par-dessus la surface de la sous-couche (6) du substrat de base (1) dans une première plage de température prédéfinie inférieure à 900 °C,
séparer la couche de renforcement (7) ensemble avec la sous-couche (6) du substrat de base (1) du reste du substrat de base (11) grâce à un traitement thermique dans une deuxième plage de température prédéfinie qui est plus élevée que la première plage de température afin de créer un pseudo substrat (10),
faire croître une couche homo- ou hétéro-épitaxiale (14) par-dessus la couche de renforcement (7) du pseudo substrat (10), et
conserver le pseudo substrat (10) dans une position sûre au sommet du reste du substrat (11) en raison de l'interaction par friction induite par une rugosité entre le pseudo substrat et le reste du substrat de base dans le but de faire croître la couche homo- ou hétéro-épitaxiale (14).

2. Procédé de fabrication d'un substrat épitaxial selon la revendication 1, dans lequel la croissance de la couche homo- ou hétéro-épitaxiale (14) se produit dans une troisième plage de température prédéfinie qui est plus élevée que la première plage de température prédéfinie.

3. Procédé de fabrication d'un substrat épitaxial selon l'une des revendications 1 ou 2, **caractérisé en ce que** la sous-couche (6) présente une épaisseur allant jusqu'à approximativement 5 µm, en particulier jusqu'à approximativement 2 µm, et plus spécifiquement une épaisseur allant jusqu'à approximativement 1 µm.

4. Procédé de fabrication d'un substrat épitaxial selon au moins l'une des revendications 1 à 3, **caractérisé en ce que** la première plage de température va environ de la température ambiante jusqu'à 900 °C, plus spécifiquement jusqu'à 800 °C, la deuxième plage de température va environ de plus de 900°C jusqu'à environ 1100 °C et/ou la troisième plage de température débute à une température supérieure à 900°C.

5. Procédé de fabrication d'un substrat épitaxial selon au moins l'une des revendications 1 à 4, **caractérisé en ce que**, avant l'implantation, une couche sacrificielle (15), en particulier une mince couche de dioxyde de silicium (SiO₂), est appliquée sur la surface (2) du substrat de base (1) au travers de laquelle l'implantation se produira.

6. Procédé de fabrication d'un substrat épitaxial selon la revendication 5, **caractérisé en ce que** la couche sacrificielle (15) est éliminée avant de fournir la couche de renforcement (7).

7. Procédé de fabrication d'un substrat épitaxial selon au moins l'une des revendications 1 à 6, **caractérisé en ce que** la couche de renforcement (7) est appliquée par dépôt, en particulier par dépôt épitaxial, plus particulièrement par épitaxie par faisceaux moléculaires (MBE), par dépôt chimique en phase vapeur à composés organométalliques (MOCVD) par épitaxie hybride en phase vapeur (HVPE) ou par pulvérisation.

8. Procédé de fabrication d'un substrat épitaxial selon au moins l'une des revendications 1 à 7, **caractérisé en ce que** l'on fait croître la couche de renforcement (7) sur une épaisseur suffisante pour autoriser un caractère autoportant du pseudo substrat (10), en particulier sur une épaisseur dans une plage allant d'approximativement 5 µm jusqu'à 50 µm, plus particulièrement dans une plage allant d'approximativement 10 µm à 40 µm.

9. Procédé de fabrication d'un substrat épitaxial selon au moins l'une des revendications 1 à 8, **caractérisé en ce que**, avant de fournir la couche de renforcement (7), la surface (2) du substrat de base (1) est traitée à l'avance en particulier par une gravure à l'acide hydrofluorhydrique (HF), une gravure au plasma ou un nettoyage standard de type un (SC1) avec un nettoyage standard de type deux (SC2).

10. Procédé de fabrication d'un substrat épitaxial selon au moins l'une des revendications 1 à 9, **caractérisé en ce que**, en addition à la couche de renforcement (7), il est fourni au moins une couche supplémentaire soit au sommet de la couche de renforcement, soit entre le substrat de base (1) et la couche de renforcement (7).

11. Procédé de fabrication d'un substrat épitaxial selon la revendication 10, **caractérisé en ce que** au moins deux couches supplémentaires sont prévues au sommet du substrat de base, ce qui crée ainsi un substrat de base modifié, et dans lequel au moins une couche supplémentaire est prévue avant l'implantation de l'espèce atomique.

12. Procédé de fabrication d'un substrat épitaxial selon la revendication 11, **caractérisé en ce que** l'espèce atomique est implantée dans la ou les couches supplémentaires du substrat de base modifié, prévues avant l'implantation de l'espèce atomique, en créant une zone à l'intérieur de la ou des couches supplémentaires parallèles pour l'essentiel à la surface, ce qui définit ainsi une interface de faiblesse.

13. Procédé de fabrication d'un substrat épitaxial selon au moins l'une des revendications 10 à 12, **caractérisé en ce que** la couche supplémentaire entre le substrat de base (1) et une couche de renforcement (7) de GaN ou autre est une couche tampon, la couche tampon étant constituée à partir d'un ou de plusieurs appartenant au groupe de l'AlN, du GaN, de l'AlGaN ou d'une combinaison de ceux-ci.

14. Procédé de fabrication d'un substrat épitaxial selon au moins l'une des revendications 1 à 13, **caractérisé en** maintenant le pseudo substrat (10) dans une position sûre au sommet du reste du substrat (11) en raison d'une friction entre le pseudo substrat (10) et le reste du substrat (11) afin de faire croître la couche supplémentaire sur le pseudo substrat (10).

15. Procédé de fabrication d'un substrat épitaxial selon au moins l'une des revendications 1 à 14, **caractérisé en ce que** le reste du substrat de base (11) est poli, en particulier par un polissage chimico mécanique, et réutilisé en temps que substrat de base (1) dans un processus suivant de préparation d'un pseudo substrat (10) après la croissance de la couche homo- ou hétéro-épitaxiale (14).

16. Procédé de fabrication d'un substrat épitaxial selon au moins l'une des revendications 1 à 15, **caractérisé en ce que** le substrat de base (1) est constitué à partir de l'un appartenant au groupe du silicium, du carbure de silicium, du saphir, de l'arséniure de gallium, du phosphure d'indium (InP) ou du germanium (Ge).

17. Procédé de fabrication d'un substrat épitaxial selon au moins l'une des revendications 1 à 16, **caractérisé en ce que** la couche épitaxiale de renforcement (7) est constituée du même matériau que la couche homo- ou hétéro-épitaxiale (14) de telle sorte que la couche homo- ou hétéro-épitaxiale (14) croisse selon un mode de croissance homo-épitaxial.

18. Procédé de fabrication d'un substrat épitaxial selon au moins l'une des revendications 1 à 17, **caractérisé en ce que** la couche de renforcement (7) présente une structure cristalline et un coefficient de dilatation thermique semblable à celui de la couche homo- ou hétéro-épitaxiale (14) de telle sorte que la couche homo- ou hétéro-épitaxiale (14) croisse selon un mode de croissance hétéro-épitaxial.

19. Procédé de fabrication d'un substrat épitaxial selon au moins l'une des revendications 1 à 18, **caractérisé en ce que** la couche de renforcement (7) est constituée d'un ou de plusieurs appartenant au groupe du nitrure de gallium (GaN), du nitrure d'aluminium (AIN), du nitrure d'indium (InN), du silicium germanium (SiGe), du phosphure d'indium (InP), de l'arséniure de gallium (GaAs) ou d'alliages constitués de ces matériaux, comme l'AlGaN, l'InGaN, l'InGaAs ou l'AlGaAs.

20. Procédé de fabrication d'un substrat épitaxial selon au moins l'une des revendications 1 à 19, **caractérisé en ce que** l'on fait croître la couche homo- ou hétéro-épitaxiale (14) dans le même appareil que la couche de renforcement (7).

21. Procédé de fabrication d'un substrat épitaxial selon les revendications 14 et 20, **caractérisé en ce que** l'on fait croître la couche supplémentaire sur le pseudo substrat (10) dans le même appareil que la couche de renforcement (7).
